Europäisches Patentamt

European Patent Office

Office européen des brevets

(11) Publication number: 0 664 502 A2

# EUROPEAN PATENT APPLICATION

(21) Application number: 95102887.7

(51) Int. Cl.6: G05F 3/22

(22) Date of filing: 25.09.91

This application was filed on 01 - 03 - 1995 as a divisional application to the application mentioned under INID code 60.

(30) Priority: 26.09.90 JP 256294/90

(43) Date of publication of application:
26.07.95 Bulletin 95/30

(60) Publication number of the earlier application in accordance with Art.76 EPC: 0 477 907

(84) Designated Contracting States:
DE FR GB

(71) Applicant: FUJITSU LIMITED
1015, Kamikodanaka
Nakahara-ku
Kawasaki-shi
Kanagawa 211 (JP)

(72) Inventor: Suwada, Makoto, c/o FUJITSU
LIMITED
Patent Department,
1015 Kamikodanaka,
Nakahara-ku
Kawasaki-shi,
Kanagawa 211 (JP)
Inventor: Inoue, Shuichi, c/o FUJITSU LIMITED
Patent Department,
1015 Kamikodanaka,
Nakahara-ku
Kawasaki-shi,
Kanagawa 211 (JP)
Inventor: Usui, Yuzo, c/o FUJITSU LIMITED
Patent Department,
1015 Kamikodanaka,
Nakahara-ku
Kawasaki-shi,
Kanagawa 211 (JP)

(74) Representative: Stebbing, Timothy Charles et al
Haseltine Lake & Co.
Hazlitt House
28 Southampton Buildings
Chancery Lane
London WC2A 1AT (GB)

(54) Oscillating circuit.

(57) An oscillating circuit (5, 6, 7) whose oscillation frequency can be varied with change of a constant current circuit output current $I_2$, which in turn can be varied with change of a power source voltage $V_{cc}$, suitable for use in portable computers. A suitable constant current circuit (1, 2, 3, 4) comprises bipolar transistors ($Q_3$, $Q_5$) coupled to form a differential amplifier (3) wherein one of the transistors ($Q_3$) is supplied with a reference voltage ($V_1$) and the other ($Q_5$) is supplied with a divided voltage of the power source voltage $V_{cc}$, and a resistor ($R_4$) connecting the emitters of the transistors is provided for controlling the slope of the $V_{cc}$-$I_2$ characteristic curve of the constant current circuit. The oscillating circuit comprises a capacitor ($C_o$) charged by current $I_2$, a switching means (SW) for discharging the capacitor when closed, and a voltage detecting means ($D_1$) operating to close or open the switching means (SW) according to the voltage at one end of the capacitor ($C_o$). Thus, the switching means switches on and off to generate pulses with a frequency depending on $I_2$, hence, depending on $V_{cc}$. Methods for controlling the frequency range of the oscillating circuit and the rise time to fall time ratio of the pulses by introducing additional constant current supplying sources are also disclosed.

*FIG.2*

The present invention relates to an oscillating circuit controlled by a constant current circuit, the oscillating circuit capable of being used as a variable-frequency clock generator in a battery-powered computer.

Various methods for saving electric power are implemented in computers powered by batteries. For example, the operating voltage is reduced in operation modes not requiring high speed, e.g. mode selection prior to arithmetic processing, together with lowering the clock signal frequency. The lower operating voltage and lower clock signal frequency both help to reduce power consumption.

In conventional battery-powered computers, one of the following techniques is used for changing the clock signal frequency. The first is to provide multiple oscillators for generating clock signals of different frequencies, and to select a suitable one of the oscillators when performing, for example, a high-speed operation such as arithmetic processing or a low-speed operation such as mode selection. The second is to provide a single oscillator of a relatively high frequency, and obtain a desired low frequency by demultiplying the high frequency. However, both these techniques involve drawbacks of requiring extra hardware such as oscillators and selecting circuits, and of increase in the cost of the computers. Another drawback of the conventional techniques is that the clock frequency cannot be continuously varied.

According to a first aspect of the present invention, there is provided an oscillating circuit, comprising a capacitor; a charging circuit coupled with a constant current circuit and charging said capacitor with a current which is equivalent to the current flowing through an output transistor in the constant current circuit; switching means connected in parallel with said capacitor; and detection means for detecting the voltage across said capacitor and instructing said switching means to open if the voltage reaches a lower predetermined voltage and to close if the voltage reaches a higher predetermined voltage.

Further aspects of the invention are as stated in the accompanying claims 2 to 5.

An embodiment of the present invention may provide an oscillating circuit capable of generating clock signals of higher frequency for operations such as arithmetic processing and of lower frequency for operations such as mode selection, with a simple circuit configuration and at low cost.

An embodiment of the present invention may also provide an oscillating circuit which generates higher or lower frequency clock signals in response to a change in the power source voltage.

An embodiment of the present invention may also provide an oscillating circuit whose oscillation frequency can be continuously changed by changing the voltage of a power supply.

Reference will now be made, by way of example, to the accompanying drawings in which:-

Fig. 1 is a diagram showing the fundamental configuration of a constant current circuit which can be used in the present invention;

Fig. 2 is a diagram showing the fundamental configuration of an oscillating circuit of the invention;

Fig. 3 is a graph showing the relationship between power voltage $V_{cc}$ and current $I_2$ in the constant current circuit of Fig. 1;

Fig. 4 is a graph for explaining the change of the slope of the $V_{cc}$-$I_2$ characteristic curve of Fig. 3 with the change of $R_4$;

Fig. 5 shows waveforms of the signal output from the oscillating circuit of Fig. 2, corresponding to different power voltages $V_{cc}$ in the constant current circuit of Fig. 1;

Fig. 6 is a graph showing the relationship between power voltage $V_{cc}$ in the circuit of Fig. 1 and oscillation frequency f in Fig. 2;

Fig. 7 is a graph showing the change of the slope of the $V_{cc}$-f curve of Fig. 6 with the change of $R_4$;

Fig. 8 is a graph for explaining an extended change of $I_2$ in the $V_{cc}$-$I_2$ characteristic of Fig. 3;

Fig. 9 is a graph for explaining an extended change of f in the $V_{cc}$-f characteristic of Fig. 6;

Fig. 10 is a diagram showing the fundamental configuration of another constant current circuit which can be used in the present invention;

Fig. 11 is a diagram showing a first embodiment of the present invention;

Fig. 12 is a graph for explaining the shift of $I_4$ in the circuit of Fig. 11;

Fig. 13 is a graph for explaining the shift of frequency f in the circuit of Fig. 11;

Fig. 14 shows waveforms of the signal output from the circuit of Fig. 11, corresponding to different values of $V_{cc}$;

Fig. 15 is a diagram showing a second embodiment of the present invention;

Fig. 16 shows waveforms of the signal output from the circuit of Fig. 15, corresponding to different values of $V_{cc}$;

Fig. 17 is a diagram showing a third embodiment of the present invention;

Fig. 18 is a graph showing the $V_{cc}$-$I_4$ characteristic of the circuit of Fig. 17;

Fig. 19 is a graph showing the $V_{cc}$-f characteristic of the circuit of Fig. 17; and

Fig. 20 shows waveforms of the signal output from the circuit of Fig. 17 for different values of $V_{cc}$.

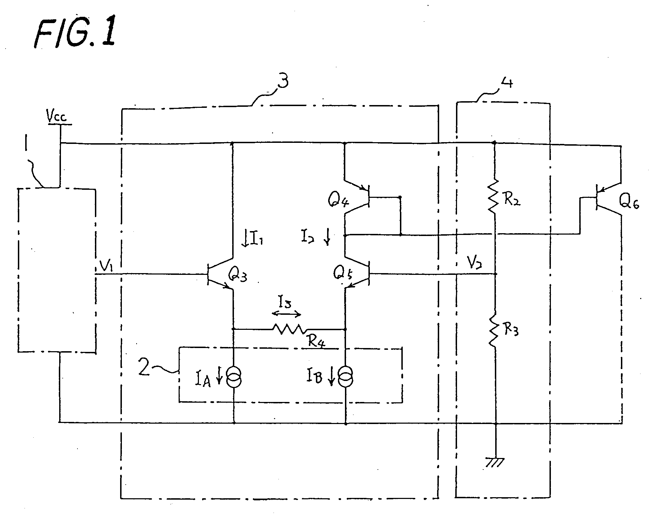

A constant current circuit which can be used in the present invention is shown in Fig. 1, which comprises a reference voltage source block 1, a differential amplifier block 3 including a constant current supplying source block 2 and a resistor $R_4$, and a voltage dividing block 4 for dividing a power source voltage $V_{cc}$.

Differential amplifier block 3 comprises transistors $Q_3$ and $Q_5$, e.g. bipolar transistors each having a collector connected to the power source voltage $V_{cc}$ and an emitter connected to one of the constant current supplying sources $I_A$ and $I_B$. The base (gate means) of the transistor $Q_3$ is supplied with a reference voltage $V_1$ from the reference voltage source block 1 and the base of transistor $Q_5$ is supplied with a divided voltage $V_2$ of power source voltage $V_{cc}$ from the node of resistors $R_2$ and $R_3$ constituting the voltage dividing block 4. The resistor $R_4$ is connected between the emitters of the transistors $Q_3$ and $Q_5$. Hence, a current $I_2$ dependent on the difference between the voltages $V_1$ and $V_2$ flows through the collector of transistor $Q_5$. The transistor $Q_4$ provided between the power voltage source $V_{cc}$ and the collector of transistor $Q_5$ constitutes a current mirror in co-operation with the transistor $Q_6$. The transistors $Q_4$ and $Q_6$ are bipolar transistors, for example, each having an emitter connected to the power voltage source $V_{cc}$ and their bases connected to each other. The base of the transistor $Q_4$ is also connected to its collector.

Characteristics and operation of the constant current circuit of in Fig. 1 are described later.

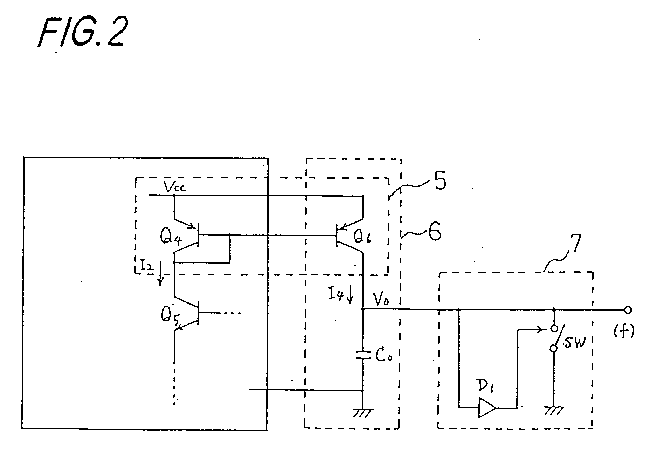

The fundamental configuration of an oscillating circuit of the present invention is as shown in figure 2, which comprises a current integration block 6 and a charge-discharge control block 7. The current integration block 6 includes aforementioned transistor $Q_6$ constituting a current mirror 5, and a capacitor $C_0$ connected between the collector of the transistor $Q_6$ and ground potential source. The capacitor $C_0$ is charged with a current $I_4$ which is substantially equal to the current $I_2$ flowing through the transistor $Q_4$, and the potential $V_0$ at a terminal of the capacitor $C_0$ increases with the charging. The charge-discharge control block 7 includes a voltage detection circuit $D_1$ and a switch means SW. The voltage detection circuit $D_1$ detects the voltage $V_0$ of the capacitor $C_0$ and instructs the switch means SW to close on detecting $V_0$ higher than a first predetermined voltage ($V_{S1}$) and to open on detecting $V_0$ lower than a second predetermined voltage ($V_{S2}$). Hence, the capacitor $C_0$ is subject to be charged or discharged along with the ON-OFF operation of the switch means SW, and $V_0$ changes as a triangular wave of a constant frequency. The frequency can be varied by changing the power source voltage $V_{cc}$ as described later.

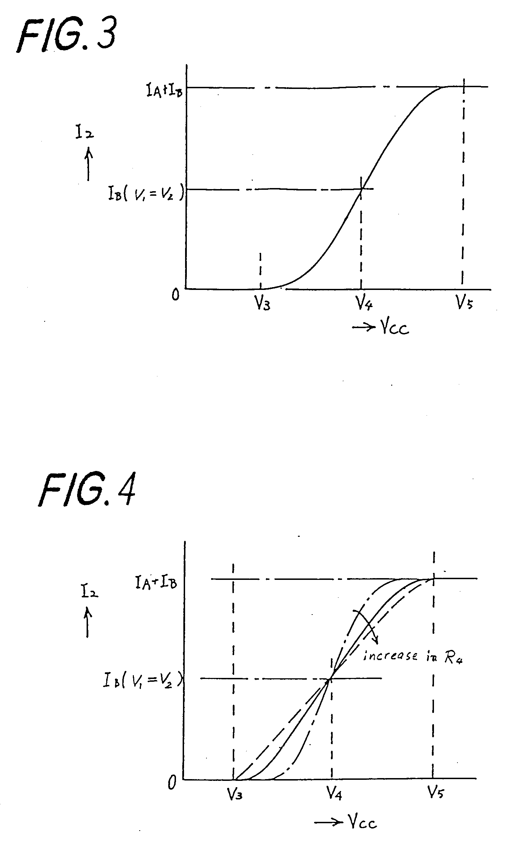

Referring again to fig. 1 together with fig. 3, the resistors $R_2$ and $R_3$ are selected so that $V_2$ is equal to $V_1$ when the power source voltage $V_{cc}$ is

$V_4$, hence, $I_2 = I_B$ and the current $I_3$ flowing through the resistor $R_4$ is zero. Under this condition, if the power source voltage $V_{cc}$ is increased higher than $V_4$, $V_2$ becomes larger than $V_1$, hence, the current $I_2$ increases while the current $I_1$ decreases. Accordingly, the current $I_3$ flows through the resistor $R_4$ from the transistor $Q_5$ to the constant current supplying source $I_A$. At a higher power source voltage $V_5$, the current $I_1$ flowing through the transistor $Q_3$ becomes almost zero, hence, $I_2 = I_A + I_B$. If the power source voltage $V_{cc}$ is decreased lower than $V_4$, $V_2$ becomes smaller than $V_1$, hence, the current $I_1$ increases while the current $I_2$ decreases. Accordingly, the current $I_3$ flows through the resistor $R_4$ from the transistor $Q_3$ to the constant current supplying source $I_B$. At a lower power source voltage $V_3$, the current $I_2$ flowing through the transistor $Q_5$ becomes almost zero, hence, $I_2 = 0$. As described above, the direction of $I_3$ flowing through $R_4$ is reversed at a $V_{cc}$ where $V_{cc} = V_4$, and $I_2$ can be changed continuously with $V_{cc}$ so as to be larger than $I_B$ in a range where $V_{cc} > V_4$ and to be smaller than $I_B$ in a range where $V_{cc} < V_4$. If $V_{cc}$ is in the range of $V_3 < V_{cc} < V_4$, $I_2$ is represented by $I_2 = I_B - I_3$. hence, $I_2 \fallingdotseq I_B - (V_1 - V_2)/R_4$, while, if $V_{cc}$ is in the range of $V_4 < V_{cc} < V_5$, $I_2$ is represented by $I_2 = I_B + I_3$. hence, $I_2 \fallingdotseq I_B + (V_2 - V_1)/R_4$. Accordingly, the larger the resistance of the resistor $R_4$, the larger the current $I_2$ in the range of $V_3 < V_{cc} < V_4$, while, the larger the resistance of the resistor $R_4$, the smaller the current $I_2$ in the range of $V_4 < V_{cc} < V_5$. Thus, the slope of the $V_{cc}$-$I_2$ characteristic curve shown in figure 3 becomes gentle with respect to the increase in $R_4$. Such change in the $V_{cc}$-$I_2$ characteristic curve by the resistance of the resistor $R_4$ is shown in figure 4. Accordingly, $I_2$ can continuously be changed with the change of $V_{cc}$, if the resistor $R_4$ is selected to have an enough large resistance. This feature enables the oscillating circuit of figure 2 to be a variable frequency oscillator.

The operation of the oscillating circuit of figure 2 with the change of the power source voltage $V_{cc}$ is described in the following.

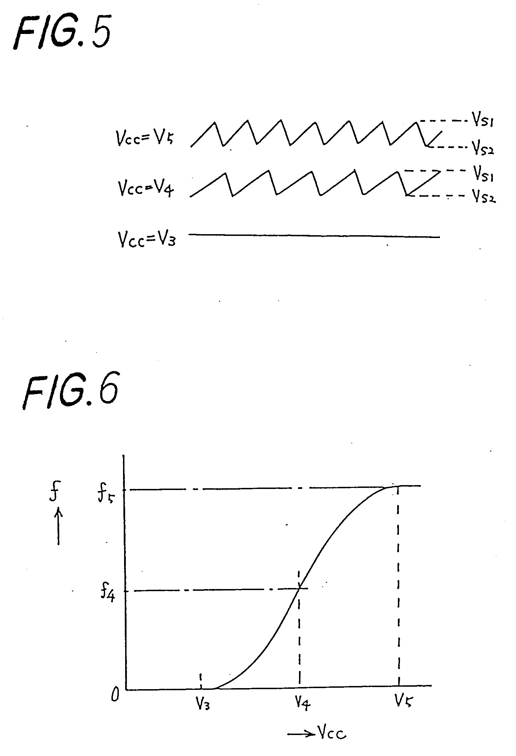

The current $I_4$ to charge the capacitor $C_0$ of the oscillating circuit is equal to $I_2$ flowing through the transistor $Q_4$ in the constant current circuit of figure 1, due to the function of the current mirror comprising the transistors $Q_4$ and $Q_6$. Hence, the rate of charging the capacitor $C_0$ depends on the current $I_2$ which can be controlled by changing the power source voltage $V_{cc}$. On the other hand, the rate of discharging the capacitor $C_0$ is constant regardless of the change of $V_{cc}$. Therefore, the frequency of oscillating circuit of figure 2 changes according to the change of the power source voltage $V_{cc}$. Figure 5 shows exemplary waveforms of the signal output from the oscillating circuit of figure 2, corresponding to aforementioned specific $V_{cc}$s of $V_3$, $V_4$ and $V_5$, and figure 6 shows the change in the frequency f of the output signal with respect to the change of $V_{cc}$. In figure 5, $V_{S1}$ and $V_{S2}$ represent the maximum and minimum of the voltages $V_0$ at an end of the capacitor $C_0$, respectively, which are detected by the voltage detection circuit $D_1$ as described above with reference to figure 2. In other words, $V_{S1}$ is a voltage $V_0$ where the discharging of the capacitor $C_0$ initiates,and, $V_{S2}$ is a voltage $V_0$ where the charging of the capacitor $C_0$ initiates. As shown in figure 5, the rise time of the output signal decreases as $V_{cc}$ increases, while the fall time of the signal is constant because it only depends on the resistance inherent in the switching means SW shown in figure 2. At a power source voltage where $V_{cc} = V_3$, the frequency of the output signal is zero as shown in figures 5 and 6, because the current $I_4$ becomes zero and the capacitor $C_0$ is not charged.

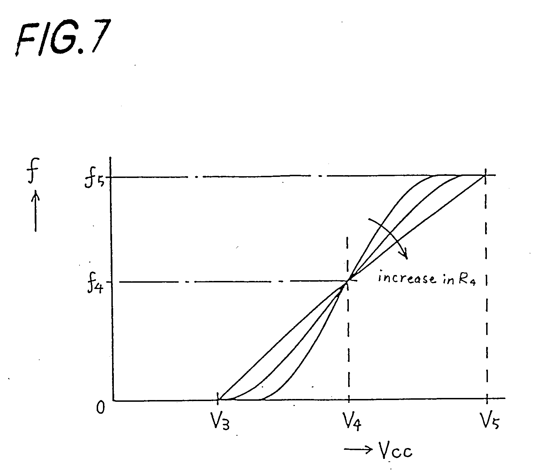

As mentioned before with reference to figure 4, the slope of $V_{cc}$-$I_2$ characteristic curve becomes gentle by increasing the resistance of the resistor $R_4$. Accordingly, the slope of $V_{cc}$-f characteristic curve shown in figure 6 becomes gentle with the increase of $R_4$ as shown in figure 7. Thus, it is possible to attain fine tuning of the oscillation frequency f by changing the power source voltage $V_{cc}$, and the circuit of figure 2 can be a variable frequency oscillator. It is obvious that if $R_4$ is decreased to zero, the slope of $V_{cc}$-$I_2$ characteristic curve of figure 4, and hence, the slope of $V_{cc}$-f characteristic curve of figure 7 become so steep that the circuit of figure 2 could not be used as a variable frequency oscillator.

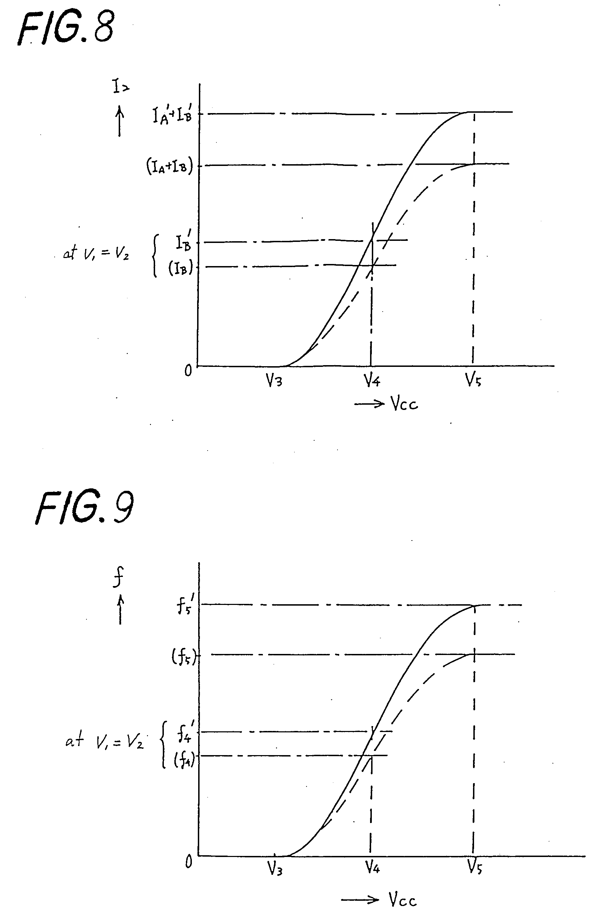

Referring back to figure 1, if the constant current supplying sources $I_A$ and $I_B$ are replaced by corresponding ones having larger current capacities $I_A$ ' and $I_B$ ' , respectively, the change of $I_2$ in the $V_{cc}$-$I_2$ characteristic curve of figure 3 is extended as shown in figure 8, hence, the change of f in the $V_{cc}$-f characteristic curve of figure 6 is extended as shown in figure 9. In figures 8 and 9, respective dotted lines represent original $V_{cc}$-$I_2$ characteristic curve corresponding to that in figure 3 and $V_{cc}$-f characteristic curve corresponding to that in figure 6, and $f_4$' and $f_5$' respectively indicate the frequencies $f_4$ and $f_5$ changed according to the increase in $I_A$ and $I_B$.

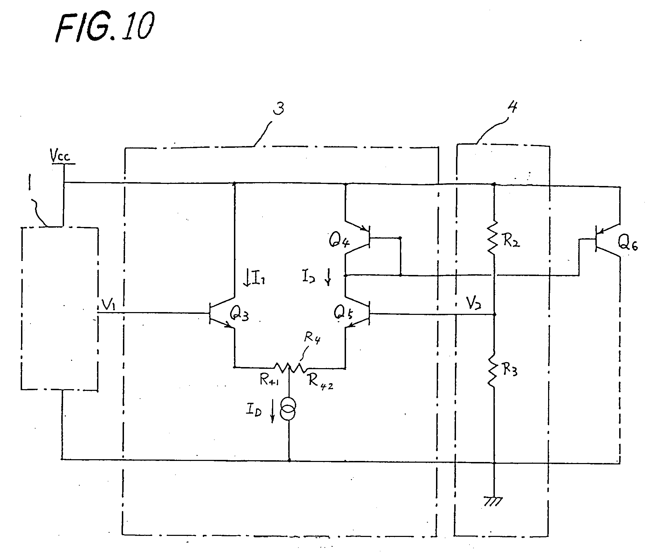

Figure 10 is a diagram showing the fundamental configurations of another constant current circuit which can be used in the invention. The circuit,comprising a reference voltage source 1, a differential amplifier block 3 and a voltage dividing block 4 for dividing power source voltage $V_{cc}$, is almost the same as the circuit of figure 1, except for that the figure 10 circuit includes only one constant current supplying source $I_D$ connected to a point on the resistor $R_4$, the point dividing $R_4$ into

two parts $R_{41}$ and $R_{42}$. If $R_4$ is equally divided, ie. $R_{41} = R_{42}$, the constant current circuit of figure 10 has the same characteristics as that of the circuit of figure 1. The feature of $R_4$ to change the slope of the $V_{cc}$-$I_2$ characteristics is also provided. When $R_4$ is not equally divided, ie. $R_{41} \neq R_{42}$ the $V_{cc}$-$I_2$ characteristic curve regarding the circuit shifts along the $V_{cc}$ axis, wherein the direction and amount of the shift depends on the ratio $R_{41}/R_{42}$.

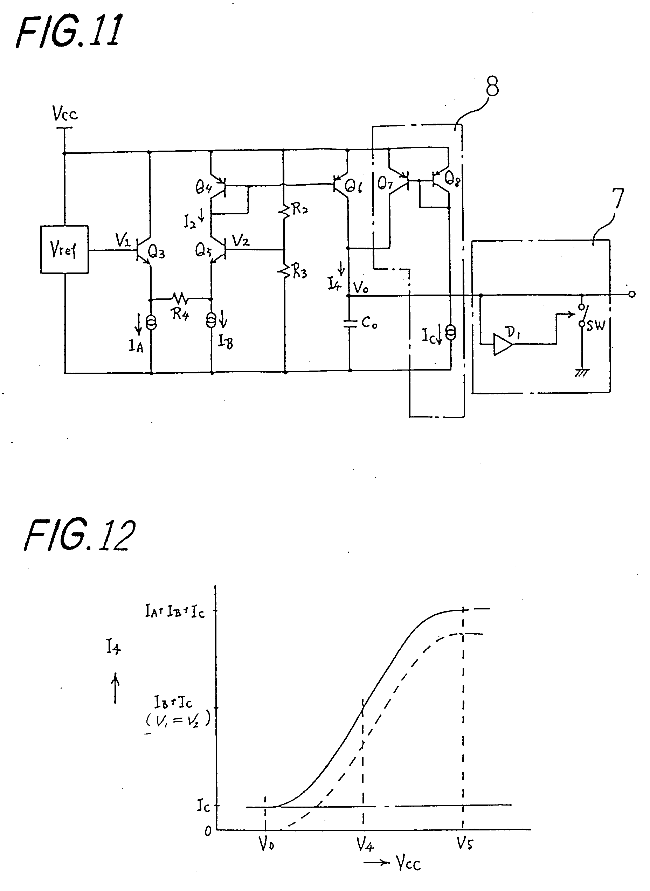

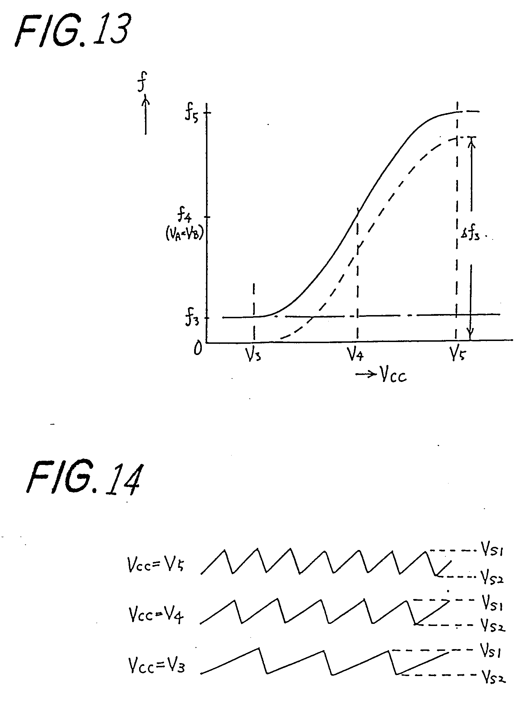

The first embodiment of the present invention is shown in figure 11, comprising a constant current circuit and an oscillating circuit which have configurations respectively based on those of figures 1 and 2. This embodiment circuit is provided with an additional constant current supplying block 8 including a current mirror comprising transistor $Q_7$ and $Q_8$,both bipolar transistors,for example, and a constant current supplying source $I_c$ connected to the collector of the transistor $Q_8$. The current $I_4$ for charging the capacitor $C_0$ is increased by the current $I_c$ such as represented by $I_4 = I_2 + I_c$. Thus, the current $I_4$ shifts larger by $I_c$ as shown in figure 12, wherein the dotted line represents the original $V_{cc}$-$I_4$ characteristic curve corresponding to that in figure 3. As a result of the shift, $I_4$ is not zero but $I_c$ at $V_{cc} = V_3$, different from $V_{cc}$-$I_2$ characteristic curve corresponding to that of the circuit shown in figure 1, in which $I_2$ is equal to $I_4$, hence, $I_4$ is zero at $V_{cc} = V_3$. Accordingly, the range of the oscillation frequency of the figure 11 circuit shifts higher by $\Delta f$ as shown in figure 13, wherein the frequency f is not zero but $f_3$ at $V_{cc} = V_3$. In figure 13, the dotted line represents the original $V_{cc}$-f characteristic curve corresponding to figure 6. Waveforms of the signal output from the circuit of figure 11 are shown in figure 14, corresponding to the specific $V_{cc}$s of $V_3$, $V_4$ and $V_5$.

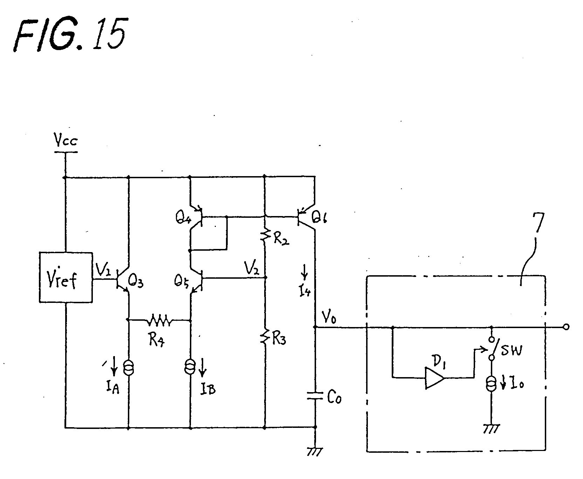

The second embodiment of the present invention is shown in figure 15, comprising a constant current circuit and an oscillating circuit which have configurations respectively based on those of figures 1 and 2. This embodiment circuit has an additional constant current supplying source $I_0$ connected in series to the switching means SW in the charge-discharge control block 7. With the addition of the constant current supplying source $I_0$, the current flowing through the switching means SW during discharging the capacitor $C_0$ is increased or decreased.

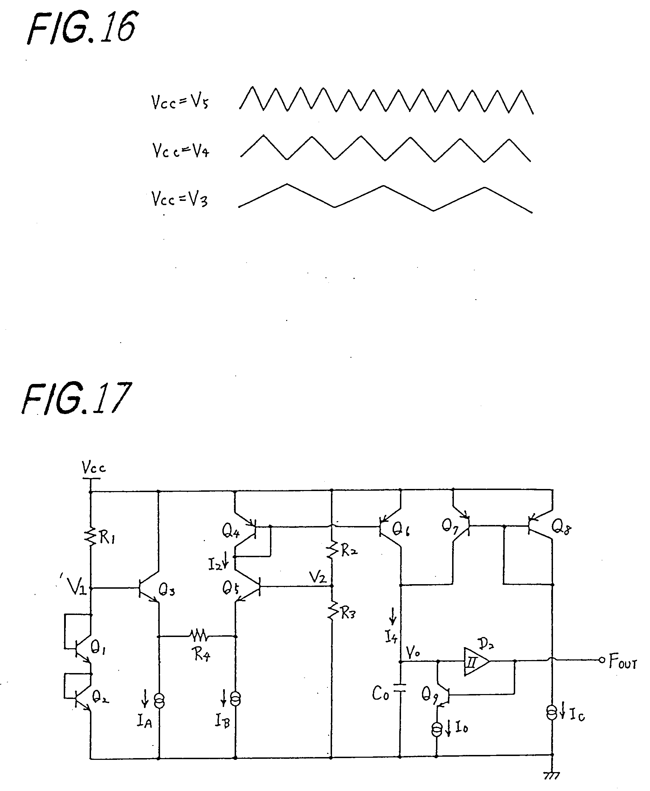

If the current $I_0$ is selected as $I_0 = nI_4$. the ratio of the time for discharging to the time for charging of the capacitor $C_0$ is represented by $1/(n-1)$, wherein n represents a positive number larger than 1. Thus, the rise time to fall time ratio of the signal output from the circuit of figure 15 can be controlled, depending on the current capacity of the constant current supplying source $I_0$. Waveforms of the signal output from the circuit of figure 15 in which the constant current supplying source $I_0$ has a current capacity of $I_0 = 2 I_4$ are shown in figure 16, corresponding to the specific $V_{cc}$s of $V_3$, $V_4$ and $V_5$. As seen in figure 16 the duty factor of each waveform is 50%.

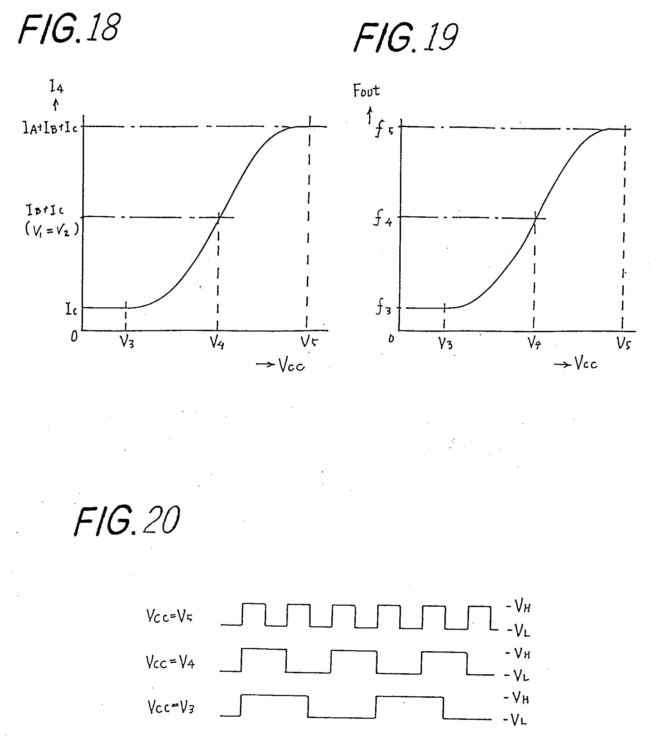

The third embodiment of the present invention is shown in figure 17, comprising a constant current circuit and an oscillating circuit which have configurations respectively based on those of figures 1 and 2. This embodiment circuit includes constant current supplying sources $I_c$ and $I_0$ introduced by the preceding embodiments described respectively with reference to figures 11 and 15. In the circuit of figure 17, the transistors $Q_1$ and $Q_2$ both bipolar transistors, for example, and a resistor $R_1$ constitute a source of reference voltage $V_1$. The base-emitter junction voltage of the transistors $Q_1$ and $Q_2$ which are connected to each other in series and supplied with a bias current is used as a constant voltage source. In figure 17, a transistor $Q_9$ is used as a switching means and a Schmitt circuit $D_2$ is used as a voltage detection circuit, respectively corresponding to those denoted by reference symbols SW and $D_1$ in figure 11 and 15. The Schmitt circuit $D_2$ converts triangular pulse signals into rectangular pulse signals thanks to the waveform shaping function thereof based on the inherent hysteresis characteristics between the input and output. The $V_{cc}$-$I_4$ characteristics and the $V_{cc}$-f characteristics of the circuit of figure 17 are as shown in figures 18 and 19, respectively.

In the circuit of figure 17, the Schmitt circuit $D_2$ has two threshold values of a high level $S_H$, and a low level $S_L$. and jumps the output $F_{out}$ thereof to high level $V_H$. if $V_0$ increases up to the high level threshold $S_H$. Hence, the transistor $Q_9$ turns on and the capacitor $C_0$ is discharged. Accodingly, the voltage $V_0$ decreases but the output remains at high level $V_H$. When the voltage $V_0$ reaches the low level threshold $S_L$. the Schmitt circuit $D_2$ jumps the output $F_{out}$ to low level $V_L$. As a result, the transistor $Q_9$ turns off and the capacitor $C_0$ is stopped from discharging and begins charging by the current $I_4$. Hence, the voltage $V_0$ increases but the output remains at low level $V_L$ until the voltage $V_0$ reaches the high level threshold $S_H$. Waveforms of the signal output from the circuit of figure 17 are shown in figure 20 corresponding to the specific power source voltages $V_{cc}$ of $V_3$, $V_4$ and $V_5$. The waveforms are obtained when the constant current supplying source $I_0$ having a current capacity of $I_0 = 2 I_4$ is used, and the rectangular pulses have a duty factor of 50%.

Any of the above embodiment circuits can be incorporated in a monolithic integrated circuit, therefore, they are suitably applied to computers like notebook-sized personal computers powered by batteries, hence, resulting in power savings of the computers by lowering the clock signal frequency and the power voltage during operations such as mode selection. The feature of variable frequency clock signals with the use of a single oscillating circuit, attained by the present invention also results in the reduction of hardware and production cost, while improving the reliability of the computers.

In the above description, examples have been given of circuits employing bipolar transistors. However, the present invention is also applicable to circuits employing other types of transistor such as FETs. In addition, the terms "resistor", "capacitor" and so forth refer to any device or circuit element (or combination of elements) having the desired property of resistance, capacitance, etc.

To summarise, the present invention concerns an oscillating circuit whose oscillation frequency can be varied with change of a constant current circuit output current $I_2$, suitable for use in portable computers. The constant current circuit output current $I_2$ can be varied with change of a power source voltage $V_{cc}$. The oscillating circuit comprises a capacitor charged by current $I_2$, a switching means for discharging the capacitor when closed, and a voltage detecting means operating to close or open the switching means according to the voltage at one end of the capacitor. Thus, the switching means switches on and off to generate pulses with a frequency depending on $I_2$, hence, depending on $V_{cc}$. A suitable constant current circuit comprises bipolar transistors coupled to form a differential amplifier wherein one of the transistors is supplied with a reference voltage and the other is supplied with a divided voltage of the power source voltage $V_{cc}$, and a resistor connecting the emitters of the transistors is provided for controlling the slope of the $V_{cc}$-$I_2$ characteristic curve of the constant current circuit. Methods for controlling the frequency range of the oscillating circuit and the rise time to fall time ratio of the pulses by introducing additional constant current supplying sources are also disclosed.

**Claims**

1. An oscillating circuit, comprising:-
   a capacitor;
   a charging circuit coupled with a constant current circuit and charging said capacitor with a current which is equivalent to the current flowing through an output transistor in the constant current circuit;
   switching means connected in parallel with said capacitor; and
   detection means for detecting the voltage across said capacitor and instructing said switching means to open if the voltage reaches a lower predetermined voltage and to close if the voltage reaches a higher predetermined voltage.

2. An oscillating circuit, comprising:-

a capacitor;

a charging circuit coupled with a constant current circuit and charging said capacitor with a current which is equivalent to the current flowing through an output transistor in the constant current circuit;

switching means connected in parallel with said capacitor;

detection means for detecting the voltage across said capacitor and instructing said switching means to open if the voltage reaches a lower predetermined voltage and to close if the voltage reaches a higher predetermined voltage; and

a constant current supplying source coupled with said capacitor for providing said capacitor with an additional charging current independent from the current flowing through said output transistor in the constant current circuit,

whereby the oscillation frequency range of said oscillating circuit is shifted to a higher frequency range by the constant current supplying source.

3. An oscillating circuit, comprising:-

a capacitor;

a charging circuit coupled with a constant current circuit and charging said capacitor with a current which is equivalent to the current flowing through an output transistor in the constant current circuit;

switching means connected in parallel with said capacitor;

detection means for detecting the voltage across said capacitor and instructing said switching means to open if the voltage reaches a lower predetermined voltage and to close if the voltage reaches a higher predetermined voltage; and

a constant current supplying source connected in series with said switching means, said constant current supplying source controlling the current flowing through said switching means, if it is closed, such that the current is n times as large as the current flowing through said output transistor in the constant current circuit, wherein n is a positive number larger than 1,

whereby the duty factor of pulses output from the oscillating circuit outputs can be changed.

4. An oscillating circuit, comprising:-

a capacitor;

a charging circuit coupled with a constant current circuit and charging said capacitor with a current which is equivalent to the current flowing through an output transistor in the constant current circuit;

switching means connected in parallel with said capacitor; and

detection means for detecting the voltage across said capacitor and instructing said switching means to open if the voltage reaches a lower predetermined voltage and to close if the voltage reaches a higher predetermined voltage;

and wherein said constant current circuit comprises:-

a source for supplying a power voltage;

two constant current supplying sources;

a first transistor having a gate means and connected between said power voltage supplying source and one said constant current supplying source, said gate means being provided with a reference voltage;

a voltage divider providing a divided voltage of said power voltage;

said output transistor, having a gate means and connected between said power voltage supplying source and the other said constant current supplying source, said gate means being provided with the divided voltage; and

a resistor connected between respective nodes of said first transistor and output transistor and said constant current supplying sources;

whereby the current flowing in said output transistor is controlled according to the magnitude of said power voltage, and the rate of change of the current with respect to change of the power voltage depends on the resistance of said resistor.

5. An oscillating circuit, comprising:-

a capacitor;

a charging circuit coupled with a constant current circuit for charging said capacitor with a current which is equivalent to the current flowing through an output transistor in the constant current circuit;

switching means connected in parallel with said capacitor; and

detection means for detecting the voltage across said capacitor and instructing said switching means to open if the voltage reaches a lower predetermined voltage and to close if the voltage reaches a higher predetermined voltage;

wherein said constant current circuit comprises:-

a source for supplying a power voltage;

first and second resistors each having a predetermined resistance and connected in series to provide each resistor with an end and a common node;

a constant current supplying source connected to the node of said resistors;

a first transistor having a gate means and connected between said power voltage supplying source and said end of said first resistor, said gate means being provided with a reference voltage;

a voltage divider providing a divided voltage of said power voltage; and

said output transistor, having a gate means and connected between said power voltage supplying source and said end of said second resistor, said gate means being provided with the divided voltage;

wherein the current flowing in said output transistor is controlled according to the magnitude of said power voltage, and the rate of change of the current with respect to change of the power voltage depends on the total resistance of said resistors.

# FIG.1

# FIG.2

# FIG.3

# FIG.4

# FIG.5

$V_{cc}=V_5$ 〜〜〜〜〜〜〜 ---- $V_{S1}$
---- $V_{S2}$

$V_{cc}=V_4$ 〜〜〜〜〜〜 ---- $V_{S1}$
---- $V_{S2}$

$V_{cc}=V_3$ ———————————

# FIG.6

# FIG.7

FIG.8

FIG.9

# *FIG.10*

## FIG.11

## FIG.12

16

# FIG.13

# FIG.14

# FIG. 15

# FIG.16

$V_{cc} = V_5$

$V_{cc} = V_4$

$V_{cc} = V_3$

# FIG.17

## FIG.18

## FIG.19

## FIG.20